# EUROPEAN PATENT APPLICATION

(11) **EP 3 640 772 A1**
(43) Date of publication of application: **22.04.2020**
(21) Application number: 17908440.5
(22) Date of filing: 03.05.2017
(51) Int. Cl.: G06F 3/0354

(54) **TOUCH CONTROL STYLUS, TOUCH CONTROL DEVICE, SYSTEM AND METHOD FOR USE IN PRACTICING CALLIGRAPHY**

(71) Applicant: Shenzhen Royole Technologies Co., Ltd., Shenzhen, Guangdong 518052 (CN)
(72) Inventor: AN, Zhi, Shenzhen Guangdong 518052 (CN); HUANG, Jiawei, Shenzhen Guangdong 518052 (CN); ZHOU, Yu, Shenzhen Guangdong 518052 (CN); CHEN, Xin, Shenzhen Guangdong 518052 (CN); PAN, Xianhong, Shenzhen Guangdong 518052 (CN)
(74) Representative: Mewburn Ellis LLP
(86) International application number: PCT/CN2017/082853
(87) International publication number: WO 2018/201317

(57) **Abstract**

A touch pen is provided. The touch pen includes a pen holder, a refill, and a main control board, and a pen tip connected to the refill and extending out of one end of the pen holder. The refill and the main control board are disposed in the pen holder. When writing by the touch pen, the pen tip forms a real handwriting and drives a touch device to generate a touch signal so as to trigger the touch device to generate touch handwriting data corresponding to the real handwriting. A touch device with the touch pen, and a system and a method for calligraphy practice are also provided, which may conveniently preserve the written handwriting.

## Description

### TECHNICAL FIELD

The present disclosure relates to the field of touch technologies, and more particularly relates to a touch pen, a touch device, and a system and a method for calligraphy practice.

### BACKGROUND

At present, existing devices for calligraphy practice are generally grooved copybooks which are customized papers having grooves printed with standard fonts. Calligraphy practice is carried out with the grooved copybook and a customized pen. However, an experience of calligraphy practice on the existing grooved copybooks is different from that on common papers. Some practitioners rely on the grooved copybook such that the effect of calligraphy practice on the common papers is not good as that on the grooved copybooks. In addition, it is not helpful for the practitioner to play their personalities in calligraphy practice in such a over-mechanized writing mode. Furthermore, the existing copybooks written are not easy to be preserved after writing.

### SUMMARY

In view of the above problems in the related art, embodiments of the present disclosure provide a touch pen, a touch device, a system and a method for calligraphy practice, which may conveniently preserve written handwritings.

A touch pen includes a pen holder, a refill, a main control board, and a pen tip connected to the refill and extending through an end of the pen holder. The refill and the main control board are disposed in the pen holder. The pen tip is electrically coupled to the main control board. The pen tip is capable of forming a real handwriting and drives a touch device to generate a touch signal at the same time so as to trigger the touch device to generate touch handwriting data corresponding to the real handwriting.

A touch device includes a touch sensing unit and a main control unit. The touch sensing unit is electrically coupled to the main control unit. The touch sensing unit is configured to sense a writing operation with a touch pen and generate a touch signal. The main control unit is configured to generate touch handwriting data according to the touch signal.

A system for calligraphy practice includes a touch device and a touch pen. The touch device includes a touch sensing unit and a main control unit. The touch sensing unit is electrically coupled to the main control unit. The touch sensing unit is configured to sense a writing operation by the touch pen and generate a touch signal. The main control unit is configured to generate touch handwriting data according to the touch signal and transmit the touch handwriting data to an electronic device communicatively coupled to the touch device, to trigger the electronic device to evaluate the touch handwriting data according to preset standard handwriting data.

A method for calligraphy practice includes following operations. At least one piece of writing paper is placed on a touch device. A writing operation with a touch pen is sensed and a real handwriting is formed on the at least one piece of writing paper at the same time. Touch handwriting data is generated according to the touch signal. The touch handwriting data is transmitted to an electronic device communicatively coupled to the touch device, to trigger the electronic device to evaluate the touch handwriting data according to a preset standard handwriting data.

The touch pen, the touch device, the system for calligraphy practice, and the method for calligraphy practice may convert the written handwriting into the touch handwriting which is capable of being stored in the form of data, thereby conveniently preserve the written handwriting.

The system and the method for calligraphy practice provide a real experience of writing on paper in calligraphy practice when carrying out calligraphy practice by the touch pen on the common paper covering the touch device. At the same time, the touch sensing unit of the touch device senses the writing operation by the touch pen and generates the touch signal. The touch handwriting data is generated according to the touch signal. The touch handwriting data is transmitted to the electronic device communicatively coupled to the touch device at the same time. The electronic device is further triggered to evaluate the touch handwriting data according to the preset standard handwriting data. Compared with existing methods for calligraphy practice, the method for calligraphy practice of the present disclosure may conveniently preserve the written handwriting and evaluate the effect of calligraphy practice in real time, remind users to correct bad writing habits in time, and improve a level of calligraphy.

### BRIEF DESCRIPTION OF THE DRAWINGS

To better illustrate the technical solutions of embodiments of the present disclosure, the following descriptions will briefly illustrate the accompanying drawings described in the embodiments.
FIG. 1 is a schematic view of a touch pen according to a first embodiment of the present disclosure.
FIG. 2A is a schematic view of a touch pen according to a second embodiment of the present disclosure.
FIG. 2B is a partial enlarged schematic view of the touch pen illustrated in FIG. 2A.
FIG. 3 is a schematic view of a protective casing for an electronic device according to a first embodiment of the present disclosure.
FIG. 4 is a schematic view of a protective casing for an electronic device according to a second embodiment of the present disclosure.
FIG. 5 is a schematic view of a cover of a protective casing for an electronic device according to a first embodiment of the present disclosure.
FIG. 6 is a schematic view of a protective casing for an electronic device according to a third embodiment of the present disclosure.
FIG. 7 is a schematic view of a cover of a protective casing for an electronic device according to a second embodiment of the present disclosure.
FIG. 8 is a schematic view of a protective casing for an electronic device according to a fourth embodiment of the present disclosure.
FIG. 9 is a schematic view of a protective casing for an electronic device according to a fifth embodiment of the present disclosure.
FIG. 10 is a schematic structural view of a system for calligraphy practice according to an embodiment of the present disclosure.
FIG. 11 is a schematic view of a data communication architecture of a system for calligraphy practice according to an embodiment of the present disclosure.
FIG. 12 is a flow chart of a method for calligraphy practice according to an embodiment of the present disclosure.

### DETAILED DESCRIPTION OF ILLUSTRATED EMBODIMENTS

The technical solutions of embodiments of the present disclosure will be described clearly and completely in combination with the accompanying drawings of the embodiments of the present disclosure. Obviously, the described embodiments are merely a part of embodiments of the present disclosure, but not all of the embodiments. All other embodiments obtained by those skilled in the art without creative efforts based on the embodiments of the present disclosure shall fall within the protection scope of the present disclosure.

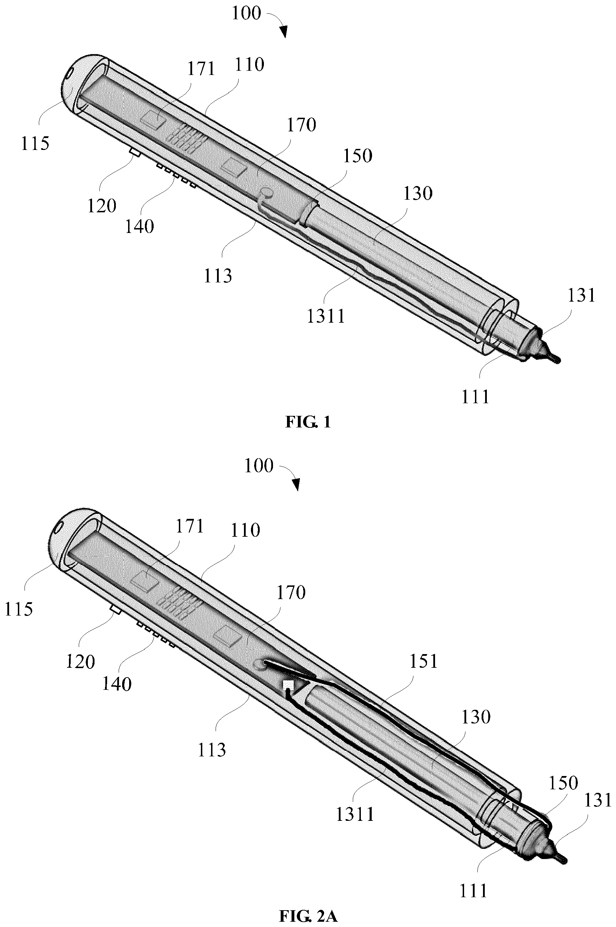

As illustrated in FIG. 1, in an embodiment of the present disclosure, a touch pen 100 of a touch device is provided. The touch pen 100 includes a pen holder 110, a refill 130, a main control board 170, and a pen tip 131 connected to the refill 130 and extending through an end of the pen holder 110. The refill 130 and the main control board 170 are disposed in the pen holder 110. The pen tip 131 is capable of forming a real handwriting. The pen tip 131 is electrically coupled to the main control board 170. When writing by the touch pen 100, the pen tip 131 forms the real handwriting, drives the touch device to generate a touch signal, and generates touch handwriting data corresponding to the real handwriting according to the touch signal.

The touch pen 100 further includes a pressure sensor 150. The pressure sensor 150 is disposed coaxially with the refill 130 and electrically coupled to the main control board 170. When writing by the touch pen 100, the pressure sensor 150 is configured to sense a touch pressure on the pen tip 131, generate pressure date corresponding to the touch pressure, and transmit the touch pressure to the main control board 170. The main control board 170 is provided with a data communication unit 171 configured to further transmit the pressure data to the touch device to trigger the touch device to combine the touch handwriting data and the pressure data to generate a three-dimensional (3D) touch handwriting corresponding to the real handwriting. In the embodiment of the present disclosure, the 3D touch handwriting includes a handwriting of Z-axis in addition to a handwriting of X-axis and Y-axis in a two-dimensional (2D) plane.

The touch device may include a capacitive touch sensor. The touch device may generate the touch handwriting data according to the touch signal generated according to a change of a coupling capacitance between the capacitive touch sensor and the touch pen 100. In the embodiment, the pressure sensor 150 and the data communication unit 171 are disposed in the touch pen 100. Thus, when the touch device is touched by the touch pen 100, the touch pressure on the pen tip 131 is sensed and the pressure data is generated to be transmitted to the touch device through the data communication unit 171 to trigger the touch device to generate the 3D touch handwriting according to the touch handwriting and the pressure data. Therefore, a 3D touch operation may be realized without disposing the pressure sensor at the touch device, that is, the 3D touch operation may be realized through touch existing touch devices without pressure sensors, which reduces production cost of the touch device.

In one embodiment, the pen holder 110 includes a head portion 111, a sleeve 113 and an end portion 115. A first end of the main control board 170 resists against the end portion 115. A second end of the main control board 170 and the refill 130 resist against opposite ends of the pressure sensor 150. The refill 130 resists against the pen tip 131. The pen tip 131 extends through the head portion 111. The pen tip 131 is made of conductive material, such as a conductive metal. The pen tip 131 is electrically coupled to the main control board 170 through a wire disposed in the refill 130 or through a wire 1311 disposed in a gap defined between the pen holder 110 and the refill 130. Accordingly, the pen tip 131 is electrically coupled to the main control board 170 and the pen tip 131 may be powered or grounded through the main control board 170. The refill 130 is configured to store ink. The pen tip 131 is in communication with the refill 130 for conducting the ink out of the refill 130 to form a real ink handwriting on a piece of writing paper. Alternatively, the refill 130 is not limited to storing ink, but may also store any fluid material that may form the real handwriting. In some embodiments, the refill 130 and the pen tip 131 may be integrally formed solid material that may form the real handwriting, such as a pencil lead or a pencil refill. The refill 130 and the pen tip 131 may be various types of common refills and pen tips that may form the real handwriting in the market, such as a ballpoint pen and a pen tip thereof, a fountain pen refill and a pen tip thereof, a felt-tip pen refill and a pen tip thereof, or even a pencil refill and a pen tip thereof, and so on. In this way, after the ink in the refill or the refill itself is used, a new refill 130 and a new pen tip 131 may easily replace the used on, or the refill 130 may be refilled with ink, which has a high versatility.

It should be understood that, writing by the touch pen 100 on the writing paper which covers the touch device may form the real handwriting. At the same time, the touch device is triggered to generate the touch signal according to the change of the coupling capacitance between the touch pen 100 and the touch device, and further generate the touch handwriting data corresponding to the real handwriting according to the touch signal. In the embodiment, the touch device may sense a touch writing operation performed by the touch pen 100 on a condition that the at least one piece of writing paper is disposed between the touch device and the touch pen. Therefore, the real handwriting is formed on the writing paper, and the touch handwriting data corresponding to the real handwriting is formed at the same time.

As illustrated in FIG. 1, in the embodiment, the pressure sensor 150 is disposed between the main control board 170 and the refill 130. Opposite ends of the pressure sensor 150 resist against the main control board 170 and the refill 130, respectively. The pressure sensor 150 is electrically coupled to the main control board 170 through an electrode (not illustrated) disposed at the second end of the main control board 170.

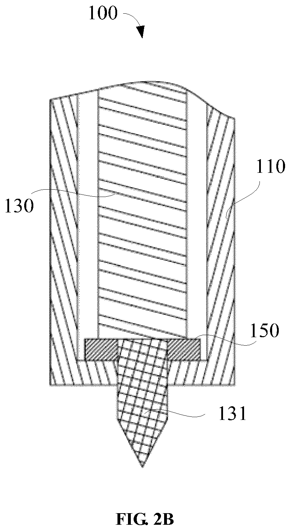

As illustrated in FIG. 2A, in one embodiment the pressure sensor 150 is sleeved on the pen tip 131 and clamped between the pen holder 110 and the refill 130. The pressure sensor 150 may be electrically coupled to the main control board 170 through a wire disposed in the refill 130, or through the wire 151 disposed in a gap defined between the pen holder 110 and the refill 130. FIG. 2B is a partial enlarged schematic view of the touch pen 100 illustrated in FIG. 2A where the pen tip 131 is located. In the embodiment, the pressure sensor 150 is annular, and the pen tip 131 extends through the pressure sensor 150 and the head portion 111 of the pen holder 110 beyond the pen holder 110.

As illustrated in FIG. 1, in the embodiment, the touch pen 100 further includes a state switching trigger unit 120 and an input state indicating unit 140. The state switching trigger unit 120 and the input state indicating unit 140 both are electrically coupled to the main control board 170. The state switching trigger unit 120 is configured to receive a trigger signal for triggering a state switching input by a user. The main control board 170 is configured to control the input state indicating unit 140 to send an input state switching prompt according to the trigger signal. The trigger signal is received after completing the writing operation on a current piece of writing paper and before starting the writing operation on a next piece of writing paper.

For example, the state switching trigger unit 120 may include a trigger button disposed at the touch pen 100. The input state indicating unit 140 may be a number of LEDs. The number of LEDs may be the same as the maximum number of pieces of writing papers disposed between the touch pen 100 and the touch device. Assumed that the touch device may normally sense the writing operation performed by the touch pen 100 when a distance between the touch pen 100 and the touch device is less than or equal to the thickness of five pieces of writing papers, five LEDs may be sequentially disposed at the touch pen 100 in a direction from top to bottom, and each LED corresponds to one piece of writing paper. After completing the writing operation on the current piece of writing paper and before starting the writing operation on the next piece of writing paper, the user triggers the corresponding LED to be off by pressing the trigger button. At the beginning, the five LEDs of the touch pen 100 are turned on. After completing the writing operation on a first piece of writing paper, the user presses the trigger button to turn off the topmost LED and keeps the other four LEDs continue to be on. In this way, the LEDs may indicate the number of the remaining pieces of writing papers to be used for the user.

It should be understood that, the distance between the touch device and the touch pen 100 is less than or equal to a preset distance threshold, that is, the thickness of all the pieces of writing papers covering the touch device is less than or equal to the preset distance threshold. In the embodiment, the preset distance threshold may be set to 5mm. In some extreme embodiments, the preset distance threshold may be set to 1-2cm when power of a touch excitation signal of the touch pen 150 is increased. It should be understood that, under a condition of being capable of sensing the handwriting input operation, the greater the preset distance threshold is, the more pieces of writing papers may cover the touch device.

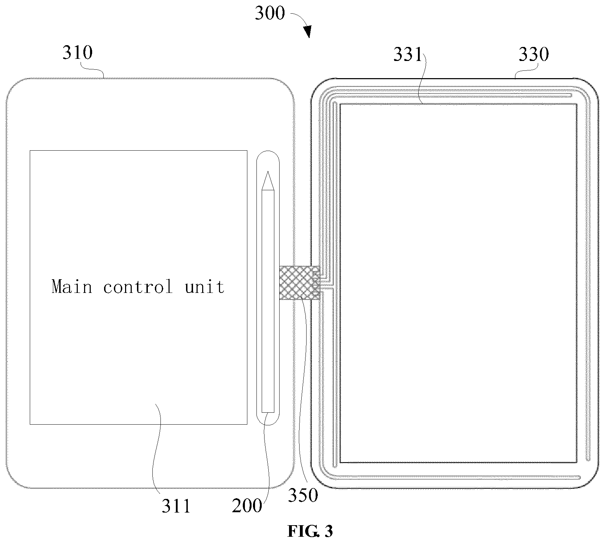

As illustrated in FIG. 3, in one embodiment of the present disclosure, a protective casing 300 for an electronic device is provided. The protective casing 300 includes a base 310, a cover 330, and a connecting member 350. The base 310 is configured to accommodate the electronic device and the touch pen 200 therein. The electronic device may be a tablet computer, a mobile phone, a video player, an E-book, and the like. The cover 330 is movably connected to the base 310 through the connecting member 350 for covering or uncovering the base 310. The touch device in the aforementioned embodiments may include the protective casing 300 in the embodiment, and may also include the protective casing 300 in the embodiment and the electronic device disposed in the protective casing 300. The cover 330 is provided with a touch sensing unit 331. The base 310 is provided with a main control unit 311 electrically coupled to the touch sensing unit 331. The touch sensing unit 331 is configured to sense the writing operation performed by the touch pen 200 on a condition that the at least one piece of writing paper is disposed between the touch device and the touch pen 200, and generate a touch signal. The main control unit 311 is configured to generate touch handwriting data according to the touch signal, and transmit the touch handwriting data to the electronic device to trigger the electronic device to evaluate the touch handwriting data according to a preset standard handwriting data. Alternatively, the main control unit 311 may also be integrated with the cover 330. The main control unit 311 may receive the pressure data sent by the touch pen 200 in a wireless manner, such as through Bluetooth, WIFI, infrared, and the like.

It should be understood that, writing by the touch pen 200 on the at least one piece of writing paper covering the cover 330, the real handwriting is formed on the writing paper. At the same time, the touch sensing unit 331 of the cover 330 may also sense the writing operation performed by the touch pen 200 and generate the touch signal during the writing operation. The main control unit 311 then generates the touch handwriting data according to the touch signal and transmits the touch handwriting data to the electronic device in real time. Accordingly, the written handwriting corresponding to the touch handwriting data may be displayed on a screen of the electronic device in real time, the touch handwriting data is compared with the preset standard handwriting data, and then the written handwriting corresponding to the touch handwriting data is evaluated or suggestions for improvement are proposed based on the comparison result.

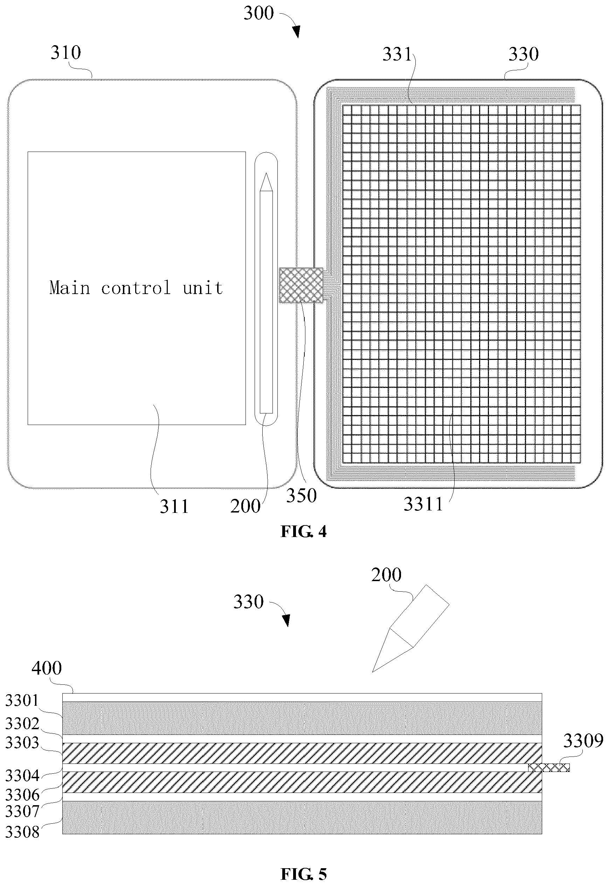

As illustrated in FIG. 4, in one embodiment, the touch sensing unit 331 includes a capacitive touch sensor 3311. The touch signal can be generated according to the change of the coupling capacitance between the captive touch sensor 3311 and the touch pen 200. In the embodiment, the touch pen 200 has a function of sensing the touch pressure and generating the pressure data. For example, the touch pen 200 may be the touch pen 100 provided by the embodiment illustrated in FIG. 1 or FIG. 2A and FIG. 2B. Details may be referred to the related description in the embodiments illustrated in FIG. 1 or FIG. 2A and FIG. 2B, and details are not described herein again.

As illustrated in FIG. 5, in the embodiment, the cover 330 may include an upper protective layer 3301, a first bonding layer 3302, a first electrode layer 3303, a second bonding layer 3304, a second electrode layer 3306, a filling layer 3307, and a lower protective layer 3308 sequentially stacked together, one below another. The first electrode layer 3303 and the second electrode layer 3306 are bonded together through the second bonding layer 3304 to form the capacitive touch sensor 3311 which is electrically coupled to the main control unit 311 through a flexible circuit board 3309. When carrying out calligraphy practice through the protective casing 300, the writing paper 400 may be placed on the upper protective layer 3301, and then the writing operation is performed by the touch pen 100 as illustrated in FIG. 1 or FIG. 2A and FIG. 2B.

It should be understood that, the touch pen 100 has the function of sensing the touch pressure and generating the pressure data. When writing by the touch pen 100 on the writing paper covering the upper protective layer 3301, the real handwriting may be formed on the writing paper to provide the user with a true experience of writing on the paper on one hand, and the touch pen 100 may sense the touch pressure during the writing operation and generate the pressure data on the other hand. At the same time, the main control unit 311 may generate the touch handwriting data according to the touch signal generated according to the change of the coupling capacitance between the capacitive touch sensor and the touch pen 100. In addition, the main control unit 311 may acquire the touch handwriting data and the pressure data, generate the 3D touch handwriting data corresponding to the real handwriting according to the touch handwriting data and the pressure data, and transmit the 3D touch handwriting data to the electronic device to trigger the electronic device to generate the 3D touch handwriting corresponding to the real handwriting. It should be understood that, the main control unit 311 may directly transmit the touch handwriting data and the pressure data to the electronic device, and the electronic device generates the 3D touch handwriting corresponding to the real handwriting according to the touch handwriting data and the pressure data.

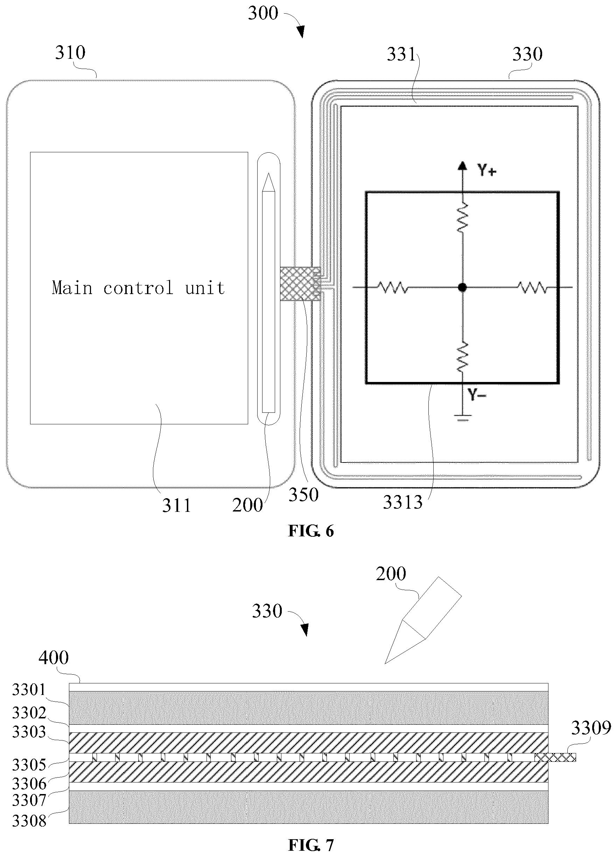

As illustrated in FIG. 6, in the embodiment, the touch sensing unit 331 includes a resistive touch sensor 3313. The resistive touch sensor 3313 is configured to sense a position and a pressure of the writing operation performed by the touch pen 200 and generate touch handwriting data and pressure data. In the embodiment, the touch pen 200 is the touch pen 100 in the embodiments illustrated in FIG. 1 and FIG. 2A and FIG. 2B, and the refill thereof may be a refill of a common hard pen, such as an ink refill, and a refill of a fountain pen, a pencil refill, and so on. In particular, the pen tip of the refill in the present embodiment may not require electric conduction, which may use an insulating material as long as normal writing may be ensured.

As illustrated in FIG. 7, in the embodiment, the cover 330 includes an upper protective layer 3301, a first bonding layer 3302, a first electrode layer 3303, and a first filling layer 3305, a second electrode layer 3306, a second filling layer 3307, and a lower protective layer 3308 sequentially stacked together, one below another. The first electrode layer 3303 and the second electrode layer 3306 are filled by the first filling layer 3305 to form the resistive touch sensor 3313 which is electrically coupled to the main control unit 311 through a flexible circuit board 3309. When carrying out calligraphy practice through the protective casing 300, the writing paper 400 may be placed on the upper protective layer 3301, and then the writing operation is performed by the touch pen 200.

It should be understood that, since the first electrode layer 3303 and the second electrode layer 3306 are filled by the first filling layer 3305 therebetween, the pressure is transmitted to the first electrode layer 3303 through the upper protective layer 3301 and the first bonding layer 3302 when writing by the touch pen 200 on the writing paper 400 covering the upper protective layer 3301 to form the real handwriting. As a result, the first electrode layer 3303 at the pressed position is deformed to contact with the second electrode layer 3306 such that a resistance of a touch loop is changed. The touch signal may be obtained by reading currents of the touch loop from four corners of the resistive touch sensor 3313, and the touch handwriting data is generated according to the touch signal. At the same time, a pressure corresponding to a change of the resistance may be calculated, thereby obtaining the pressure data. Furthermore, the main control unit 311 acquires the touch handwriting data and the pressure data to be transmitted to the electronic device. The electronic device generates the 3D touch handwriting corresponding to the real handwriting according to the touch handwriting data and pressure data. Alternatively, the main control unit 311 may generate the touch handwriting data corresponding to the real handwriting according to the touch handwriting data and the pressure data, and transmit the 3D touch handwriting data to the electronic device to trigger the electronic device to generate the 3D touch handwriting corresponding to the real handwriting. Of course, it should be understood that, the touch pen 200 may be integrated with the pressure sensor 150 to obtain more accurate pressure data.

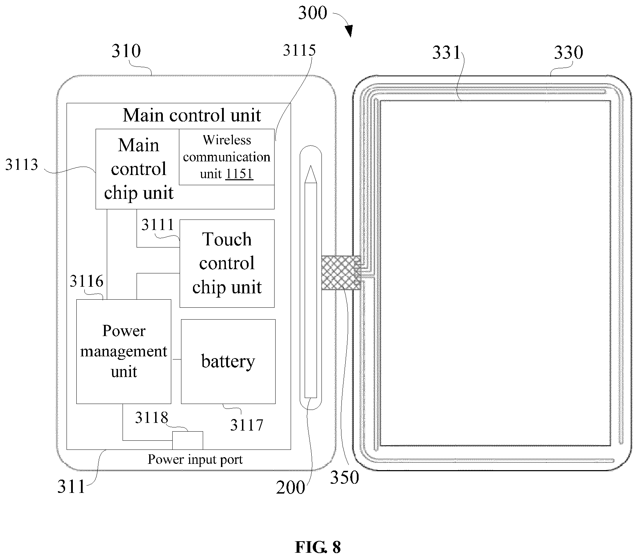

As illustrated in FIG. 8, the main control unit 311 includes a touch control chip unit 3111, a main control chip unit 3113, and a data transmission unit 3115. The touch control chip unit 3111, the main control chip unit 3113 are electrically coupled to the touch sensing unit 331, for acquiring the touch handwriting data and the pressure data. The data transmission unit 3115 is electrically coupled to the main control chip unit 3113, to transmit the touch handwriting data and pressure data to the electronic device. It should be understood that, since the touch sensing unit 331 includes the capacitive touch sensor 3311, or the resistive touch sensor 3313, and the touch pen 200 is integrated with the pressure sensor 150, the data transmission unit 3115 is further configured to receive the pressure data sent by the touch pen 200. It should be understood that, in one embodiment, the main control chip unit 3113 may directly generate the 3D touch writing data according to the touch handwriting data and the pressure data and the data transmission unit 3115 transmit the 3D touch writing data to the electronic device, to trigger the electronic device to generate the 3D touch handwriting corresponding to the real handwriting.

The data transmission unit 3115 further includes a wireless communication unit 1151 configured to establish a wireless communication connection with the electronic device and transmit the touch handwriting data and pressure data to the electronic device. For example, the wireless communication unit 1151 may be a Bluetooth communication unit. It should be understood that, in one embodiment, the wireless communication unit 1151 may be integrated into the main control chip unit 3113.

The main control unit 311 further includes a power management unit 3116 and a battery 3117. The power management unit 3116 is electrically coupled to the touch control chip unit 3111, the main control chip unit 3113, the data transmission unit 3115, and the touch sensing unit 331, configured for powering the protective casing 300. The power management unit 3116 may connect an external power source through a power input port 3118 to obtain a power from the external power source to charge the battery 3117.

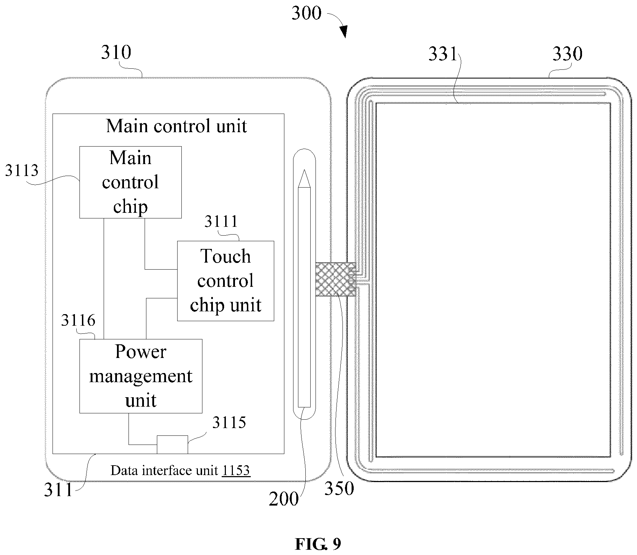

As illustrated in FIG. 9, in the embodiment the data transmission unit 3115 includes a data interface unit 1153. The data interface unit 1153 is configured to establish a wired communication connection with the electronic device, and transmit the touch handwriting data and the pressure data to the electronic device by the wired communication. For example, the data interface unit 1153 may be a Micro USB interface. The power management unit 3116 may be electrically coupled to the electronic device through the data interface unit 1153 to directly obtain power from the electronic device, thereby omitting the battery.

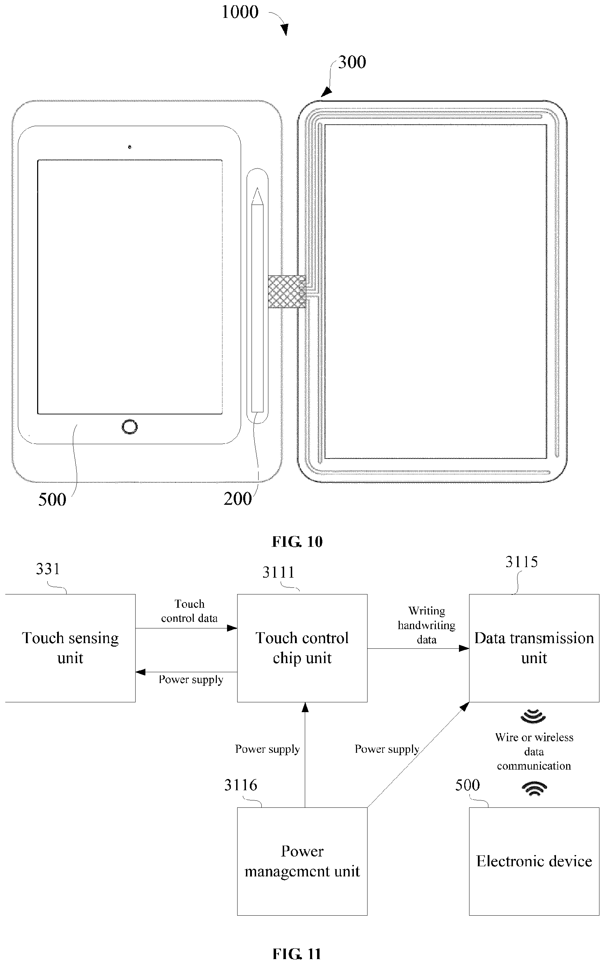

As illustrated in FIG. 10, in one embodiment of the present disclosure, a system 1000 for calligraphy practice is provided. The system 1000 including the touch pen 200, the protective casing 300, and the electronic device 500. The specific structures and functions of the protective casing 300 may refer to the relating descriptions in the embodiments illustrated in FIG. 3 to FIG. 9. The touch pen 200 may be a normal hard pen or the touch pen 100 as described in the embodiment illustrated in FIG. 1 or FIG. 2A and FIG. 2B. When writing by the touch pen 200 on at the least one piece of writing paper covering the cover 330 of the protective casing 300, an ink writing is formed on at the least one piece of writing paper.

FIG. 11 illustrates a data communication architecture between the touch sensing unit 331, the touch control chip unit 3111, the data transmission unit 3115, and the electronic device 500. The power management unit 3116 is configured to power the touch control chip unit 3111 and the data transmission unit 3115. The touch sensing unit 331 may be powered by the touch control chip unit 3111. When writing by the touch pen 200 on the writing paper to form the real handwriting, the touch sensing unit 331 may sense the writing operation performed by the touch pen 200 and generate the trigger signal. The touch control chip unit 3111 and the main control chip unit 3113 generate the touch handwriting data according to the trigger signal to be transmitted to the transmission unit 3115. The transmission unit 3115 transmits the touch handwriting data to the electronic device 500 in real time. Accordingly, the written handwriting corresponding to the touch handwriting data may be displayed on the screen of the electronic device 500 in real time. The electronic device 500 compares the touch handwriting data with the preset standard handwriting data, and then evaluates the written handwriting or proposes improvement suggestions based on the comparison result.

In one embodiment, if the touch sensing unit 331 of the protective casing 300 includes the capacitive touch sensor 3311, the touch pen 200 may be the touch pen 100 as illustrated in FIG. 1 or FIG. 2A and FIG. 2B. The touch signal is generated according to the change of the coupling capacitance between the capacitive touch sensor 3311 and the touch pen 100. The touch control chip unit 3111 and the main control chip unit 3113 further generate the touch handwriting data according to the touch signal. At the same time, the touch pen 100 senses the touch pressure and generates the pressure data. The data transmission unit 3115 further acquires the pressure data from the touch pen 100 and transmit the pressure data to the main control chip unit 3113. The main control chip unit 3113 further generates the 3D touch handwriting data according to the touch handwriting data and the pressure data, and transmits the 3D touch handwriting data to the electronic device 500 through the data transmission unit 3115. Alternatively, the main control chip unit 3113 may directly transmit the touch handwriting data and the pressure data to the electronic device 500. The electronic device 500 generates the 3D touch handwriting.

In one embodiment, if the touch sensing unit 331 of the protective casing 300 includes the resistive touch sensor 3313. The resistive touch sensor 3313 senses the position and the touch pressure of the writing operation performed by the touch pen. The touch control chip unit 3111 and the main control chip unit 3113 generate the touch handwriting data and the pressure data to be transmitted to the electronic device 500. Alternatively, the pressure sensor of the touch pen 200 may output the pressure data. The touch control chip unit 3111 and the main control chip unit 3113 further generate the 3D touch handwriting data according to the touch handwriting data and the pressure data. The data transmission unit 3115 transmits the 3D touch handwriting data to the electronic device 500.

It should be understood that, he data transmission unit 3115 may transmit the touch handwriting data and the pressure data to the electronic device 500, and the electronic device 500 may generate the 3D touch handwriting according to the touch handwriting data and the pressure data.

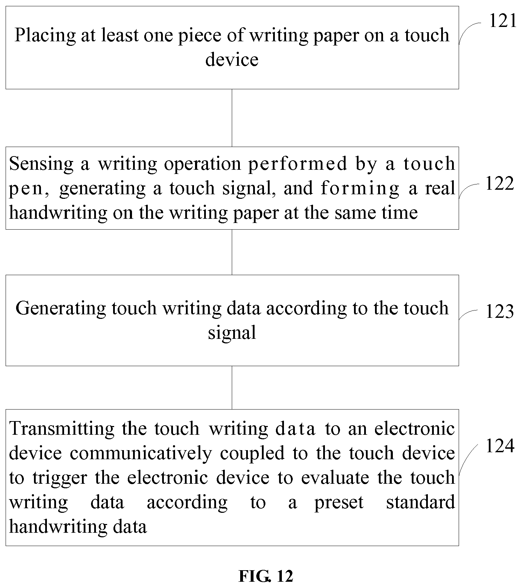

As illustrated in FIG. 12, in an embodiment of the present disclosure, a method for calligraphy practice applied to the system 1000 illustrated in FIG. 10 to FIG. 11 is provided. The method for calligraphy practice includes operations at the following blocks.

At block 121, the at least one piece of writing paper is placed on the touch device.

At block 122, the writing operation performed by the touch pen on the at least one piece of writing paper is sensed and the touch signal is generated. At the same time, the real handwriting is formed on the writing paper.

At block 123, the touch handwriting data is generated according to the touch signal.

At block 124, the touch handwriting data is transmitted to the electronic device communicatively coupled to the touch device to trigger the electronic device to evaluate the touch handwriting data according to the preset standard handwriting data.

In one embodiment, when the writing operation performed by the touch pen on the at least one piece of writing paper is sensed and the touch signal is generated, the method further includes the following operations.

The pressure data is generated by sensing a touch pressure on the pen tip of the touch pen through a pressure sensor disposed in the touch pen.

The pressure data is acquired through the touch device, and the pressure data together with the touch handwriting data is transmitted to the electronic device.

In one embodiment, "trigger the electronic device to evaluate the touch handwriting data according to the preset standard handwriting data" further includes the following operations.

The electronic device is triggered to compare the touch handwriting data with the preset standard handwriting data to generate evaluations and suggestions for improvement output by a voice or a display screen.

It should be understood that, the specific implementations of each operation in the method for calligraphy practice may also refer to the related descriptions in the embodiments illustrated in FIG. 10 to FIG. 11, and details are not described herein again.

The system and method for calligraphy practice allow performing the writing operation by the touch pen on the writing papers covering the touch device, which provides the true experience of writing on papers in calligraphy practice. At the same time, the touch sensing unit of the touch device senses the writing operation performed by the touch pen, generates the touch signal, and generates the touch handwriting data according to the touch signal. The touch handwriting data is synchronized to the electronic device communicatively coupled to the touch device in real time. The electronic device is further triggered to evaluate the touch handwriting data according to the preset standard handwriting data. Compared with existing methods for calligraphy practice, the method for calligraphy practice of the present disclosure may conveniently preserve the written handwriting and evaluate the effect of calligraphy practice in real time, remind the user to correct bad writing habits in time, and improve a level of calligraphy.

The embodiments of the present disclosure are described in detail above. It should be noted that those skilled in the art may make some modifications and improvements without departing from the principle of the present disclosure. Those modifications and improvements are also considered to be within the scope of the present disclosure.

## Claims

1. A touch pen for a touch device, comprising:
a pen holder,
a refill disposed in the pen holder;
a main control board disposed in the pen holder; and
a pen tip connected to the refill and extending through one end of the pen holder, wherein the pen tip is electronically coupled to main control board; the pen tip capable of writing a real handwriting and driving the touch device to generate a touch signal at the same time, so as to trigger the touch device to generate touch handwriting data corresponding to the real handwriting.

2. The touch pen of claim 1, wherein the touch pen further comprises a pressure sensor disposed in the pen holder and electrically coupled to the main control board, wherein the pressure sensor is configured to sense a pressure on the pen tip and generate pressure data when writing by the touch pen.

3. The touch pen of claim 2, wherein the pressure sensor transmits the pressure data to the main control board when writing by the touch pen, wherein the main control board is further configured to transmit the pressure data to the touch device, and the touch handwriting data and the pressure data are combined to generate a three-dimensional (3D) touch handwriting corresponding to the real handwriting.

4. The touch pen of claim 2, wherein the pressure sensor is disposed between the main control board and the refill, with opposite ends of the pressure sensor resisting against the main control board and the refill, respectively.

5. The touch pen of claim 2, wherein the pressure sensor is sleeved on the pen tip and clamped between the pen holder and the refill.

6. The touch pen of claim 5, wherein the pressure sensor is annular, and the pen tip extends through the pressure sensor and beyond the pen holder.

7. The touch pen of claim 2, wherein the pressure sensor is electrically coupled to the main control board through a wire disposed in the refill or a wire disposed in a gap defined between the pen holder and the refill.

8. The touch pen of any one of claim 1 to claim 7, wherein the pen tip is made of conductive material, and electrically coupled to the main control board through a wire disposed in the refill or a wire disposed in a gap between the pen holder and the refill.

9. The touch pen of any one of claim 1 to claim 7, wherein the refill is configured to store ink, wherein the pen tip is in communication with the refill to conduct the ink out the refill and form an ink handwriting.

10. The touch pen of any one of claim 1 to claim 7, wherein when writing by the touch pen, the pen tip forms the real handwriting on a piece of writing paper covering a surface of the touch device and drives the touch device to generate the touch signal at the same time.

11. A touch device for a touch pen, comprising:
a touch sensing unit configured to sense a writing operation performed with the touch pen and generate a touch signal; and
a main control unit electrically coupled to the touch sensing unit and configured to generate touch handwriting data according to the touch signal.

12. The touch device of claim 11, wherein the touch sensing unit comprises a capacitive touch sensor, wherein the capacitive touch sensor is configured to form a coupling capacitance between the touch pen and the capacitive touch sensor, and to further generate the touch signal according to a change of the coupling capacitance.

13. The touch device of claim 11, wherein the main control unit comprises a touch control chip unit, a main control chip unit, and a data transmission unit, wherein the touch control chip unit is electrically coupled to the touch sensing unit for acquiring the touch signal, and the main control chip unit is configured to transmit the touch handwriting data to an electronic device communicatively coupled to the touch device through the data transmission unit.

14. The touch device of claim 13, wherein the data transmission unit is further configured to acquire pressure data transmitted from the touch pen and to transmit the pressure data together with the touch handwriting data to the electronic device.

15. The touch device of claim 11, wherein a surface of the touch sensing unit surface is further covered with a piece of writing paper, wherein the touch sensing unit senses the touch handwriting performed by the touch pen and a real handwriting is formed on the piece of writing paper at the same time.

16. The touch device of claim 11, wherein the touch device comprises a protective casing for an electronic device, wherein the protective casing comprises a base configured to accommodate the electronic device, a cover, and a connecting member, wherein the cover is movably connected to the base through the connecting member and capable of covering or uncovering the base, wherein the touch sensing unit is disposed at the cover.

17. A system for calligraphy practice for an electronic device, the system comprising:
a touch pen; and
a touch device comprising:
a touch sensing unit configured to sense a writing operation performed by the touch pen and generate a touch signal; and
a main control unit electrically coupled to the touch sensing unit, wherein the main control unit is configured to generate touch handwriting data according to the touch signal, and transmit the touch handwriting data to the electronic device communicatively coupled to the touch device to trigger the electronic device to evaluate the touch handwriting data according to a preset standard handwriting data.

18. The system of claim 17, wherein touch pen comprises a pen holder, a refill, a main control board, and a pen tip connected to the refill and extending through one end of the pen holder, wherein the refill and the main control board are disposed in the pen holder, and the pen tip is electrically coupled to the main control board to drive the touch device to generate a touch signal.

19. The system of claim 18, wherein the touch pen is the touch pen of any one of claim 2 to claim 10.

20. The system of claim 17, wherein the touch device is the touch device of any one of claim 11 to claim 16.

21. A method for calligraphy practice in the system of any one of claims 17 to 20, the method comprising:
placing at least one piece of writing paper on the touch device;
sensing the writing operation performed by the touch pen and generating a touch signal, and forming a real handwriting on the writing paper at the same time;
generating touch handwriting data according to the touch signal; and
transmitting the touch handwriting data to the electronic device communicatively coupled to the touch device to trigger the electronic device to evaluate the touch handwriting data according to the preset standard handwriting data.

22. The method of claim 21, wherein when sensing the writing operation performed by the touch penperformed by the touch pen and generating a touch signal, the method further comprising:
generating pressure data by sensing a touch pressure on the pen tip of the touch pen through a pressure sensor disposed in the touch pen; and
acquiring the pressure data through the touch device and transmitting the pressure data together with the touch handwriting data to the electronic device.

23. The method of claim 21, wherein "trigger the electronic device to evaluate the touch handwriting data according to a preset standard handwriting data", comprising:
triggering the electronic device to compare the touch handwriting data with the preset standard handwriting data to generate evaluations and suggestions for improvement output by a voice or a display screen.
